# EUROPÄISCHE PATENTANMELDUNG

(11) **EP 0 708 583 A1**
(43) Veröffentlichungstag der Anmeldung: **24.04.1996**
(21) Anmeldenummer: 95113528.4
(22) Anmeldetag: 29.08.1995
(51) Int. Cl.: H05K 5/00

(54) **Elektrisches Gerät und Verfahren zu dessen Herstellung**

(30) Priorität: 21.10.1994 DE 4437664
(71) Anmelder: ROBERT BOSCH GMBH, D-70442 Stuttgart (DE)
(72) Erfinder: Feucht, Gunther, D-71735 Eberdingen (DE); Bentz, Willy, D-74343 Sachsenheim (DE); Hussmann, Dieter, D-71711 Steinheim (DE); Gansert, Willi, Dipl.-Ing.(FH), D-70806 Kornwestheim (DE); Wiesa, Thomas, Dipl.-Ing., D-71665 Vaihingen (DE); Karr, Dieter, Dipl.-Phys., D-75233 Tiefenbronn (DE); Schimitzek, Ralph, Dipl.-Ing. (FH), D-74182 Obersulm/Sulzbach (DE)

(57) **Zusammenfassung**

Es wird ein elektrisches Gerät und ein Verfahren zu dessen Herstellung vorgeschlagen, bei dem auf mindestens einer, teilweise aus flexiblem Material bestehenden, Leiterplatte (2) elektrische Bauelemente (9,11) angeordneten sind. Weiterhin sind flexible elektrische Leiterbahnen (3;13), eventuell mit Steckverbindern (16), vorhanden, die mit der Leiterplatte (2) verbunden oder in diese integriert sind. Um einen kompakten Aufbau und optimale Einsatzmöglichkeiten für das elektrische Gerät (1) zu schaffen sind die mindestens eine Leiterplatte (2) , die Gehäuseteile (4,5) und zumindest Teile der flexiblen Leiterbahnen (3;13) mit einer zunächst flüssigen, danach aushärtenden Schaumstoffmasse (6;17) derart umgeben, daß eine mechanisch haltbare Verbindung zwischen diesen Elementen hergestellt ist.

## Beschreibung

### Stand der Technik

Die Erfindung betrifft ein elektrisches Gerät und ein Herstellungsverfahren für das elektrische Gerät nach dem Oberbegriff des Hauptanspruchs.

Es ist bereits aus der DE-OS 40 35 526 ein elektrische Gerät bekannt, bei dem eine Leiterplatte aus zwei Teilen gebildet ist, die über einen mittleren Bereich mit flexiblen Leiterbahnen miteinander verbunden sind. Die beiden Bereiche sind jeweils an Gehäuseteilen gehalten, die aus gut wärmeleitendem Material sind, sodaß auch Leistungsbauelemente mit einer entsprechenden Wärmeabgabe auf diesen Leiterplatten untergebracht werden können. Weitere flexible Bereiche der Leiterplatten sind mit Steckverbindern oder sonstigen Anschlußteilen verbunden, die einen universellen Einsatz des elektrischen Geräts gewährleisten.

Während des Zusammenbaus des elektrischen Geräts werden die Leiterplatten zur einfacheren Bestückung zunächst flächig ausgeklappt gehalten und gegebenenfalls an Gehäuseteilen befestigt. Nach der Beendigung der Bestückung können die Leiterplattenbereiche mitsamt ihren Gehäuseteilen über die flexiblen Bereiche derart zusammengeklappt werden, daß sich ein kompaktes elektrisches Gerät ergibt, bei dem die wärmeableitenden Gehäuseteile und die Anschlußbereiche außen liegen und die Leiterplatten eventuell auch abdichtend umschließen.

### Vorteile der Erfindung

Das erfindungsgemäße elektrische Gerät mit den kennzeichnenden Merkmalen des Anspruchs 1 ist insbesondere dadurch vorteilhaft, daß die Fixierung und der endgültige Zusammenhalt der Leiterplatten mit den Gehäuseteilen auf einfache Weise mit der Schaumstoffeinbettung herstellen läßt. Als Anwendungsgebiet für das elektrische Gerät kommt insbesondere eine Ausführung als Steuergerät für die Motorsteuerung eines Kraftfahrzeuges in Betracht, da aufgrund des kompakten Aufbaus mit der dichtenden Einbettung der elektrischen Bauelemente in die Schaumstoffmasse ein Einsatz auch unter schwierigen Bedingungen möglich ist. Insbesondere durch eine schrittweise Anbringung von Leistungsbauteilen auf wärmeableitenden Gehäuseteilen und der anschließenden Kontaktierung mit den Leiterplatten den nach außen geführten Anschlußelementen vor der endgültigen Fixierung der mechanischen Teile ist ein einfacher Aufbau gewährleistet.

Die Gehäuseteile sind gemäß der Erfindung vorzugsweise einfache Aluminiumplatten die durch die Schaumstoffmasse in Verbindung mit den flexiblen Leiterbahnen zu einer geeigneten Gehäuseform gestaltet werden können. Zusätzliche mechanische Verbindungsteile sind hierbei nicht erforderlich, da die Haftwirkung der Schaumstoffmasse zu einer ausreichenden Festigkeit des Gehäuses führt. Auch sind spezielle Rahmen für die Gehäuseteile oder die Leiterplatten damit überflüssig. Auch eine Abdichtung der Leiterplatten und der Anschlußteile ist durch die Schaumstoffmasse in hervorragender Weise gewährleistet, wobei auch im Inneren des Gehäuses eine thermische Trennung von Leistungsbauelementen von empfindlichen Logikschaltkreisen über die Schaumstoffmasse einfach herstellbar ist. Leistungsbauelemente, die eine besondere Kühlung benötigen, können hierbei in der Nähe von metallischen Befestigungsteilen des elektrischen Geräts untergebracht werden; auch eine Herausführung von Gehäuseteilen an eventuell vorhandene kühlende Luftströmungen ist auf einfache Weise durchführbar.

Vorteilhafte Ausführungsformen des elektrischen Geräts sind in den Unteransprüchen angegeben. Besonders vorteilhaft ist, wenn Verbindungsleitungen zu externen Bauteilen, wie zum Beispiel Druckregler, Winkelgeber, und sonstige Sensoren über flexible Leiterbahnen mit in die Schaumstoffmasse eingebettet werden. Ein geeignetes Herstellungsverfahren für das elektrische Gerät ist im Anspruch 9 beschrieben, wobei in besonders vorteilhafter Weise als Schaumstoffmaterial Polyurethan (PUR) verwendet werden kann.

### Zeichnung

Ausführungsbeispiele des erfindungsgemäßen elektrischen Geräts werden anhand der Zeichnung erläutert. Es zeigen:
Figur 1 einen Schnitt durch ein erstes Ausführungsbeispiel eines elektrischen Geräts mit aushärtender Schaumstoffmasse;
Figur 2 einen Schnitt durch ein zweites Ausführungsbeispiel eines solchen elektrischen Geräts;
Figur 3 ein Ausführungsbeispiel einer Leiterplatte des elektrischen Geräts vor dem Zusammenbau;
Figuren 4A und 4B jeweils einen Schnitt durch ein zweites Ausführungsbeispiel des elektrischen Geräts mit der Leiterplatte nach Figur 3 in verschiedenen Ansichten und
Figur 5 einen Schnitt durch ein drittes Ausführungsbeispiel des elektrischen Geräts mit aus dem Gehäuse herausgeführten Anschlußelementen.

### Beschreibung der Ausführungsbeispiele

In der Figur ist ein Schnitt durch ein erstes Ausführungsbeispiel durch ein fertig montiertes, elektrisches Gerät 1 gezeigt, das im Inneren eine zumindest teilweise flexible Leiterplatte 2 (beispielsweise aus Polyamid) enthält. Die obere und die untere Schaltungsebene der Leiterplatte 2 sind über flexible Leiterbahnen 3 miteinander verbunden. Gehäuseteile 4 und 5 (beispielsweise aus Aluminium) bilden hierbei in Verbindung mit einer aushärtenden Schaumstoffmasse 6 aus PUR das mechanische Gerüst für das elektrische Gerät 1. Eine Befestigung des elektrischen Geräts 1, beispielsweise im Motorraum eines Kraftfahrzeuges, kann über das obere Gehäuseteil 4 mittels Schrauben 7 an Halteelementen 8 vorgenommen werden.

Auf der Leiterplatte 2 sind auf der unteren Schaltungsebene elektronische Bauelemente 9 angeordnet, die beispielsweise die Steuerelektronik oder ähnliche Logikschaltkreise darstellen. Beim hier gezeigten Ausführungsbeispiel sind die Bauelemente 9 auf der Außenseite des Gehäuseteils 5 angebracht und durch dieses durchkontaktiert sowie mit einer metallischen Abschirmung 10 versehen. Es ist hier eine optimale Abschirmung der Bauelemente 9 gegenüber Leistungsbauelementen 11 oder Steckverbindern 12 an der oberen Schaltungsebene gewährleistet. Das Leistungsbauelement 11 ist hierbei in der Nähe des rechten Anschlußelements 8 angeordnet, sodaß eine optimale Wärmeableitung an das zumeist metallische Anschlußelelement 8 gewährleistet ist.

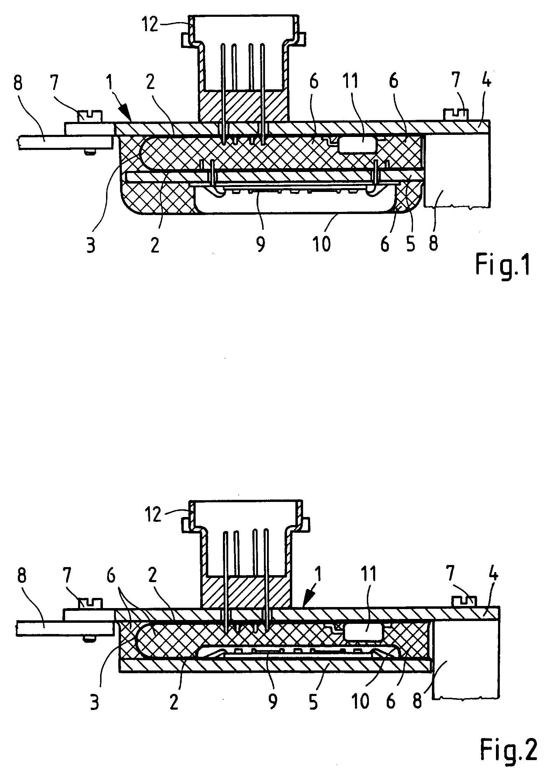

In Figur 2 ist eine geänderte Variante des Ausführungsbeispiels nach Figur 1 gezeigt, wobei hier die Bauelemente 9 und die Abschirmung 10 im Innenraum des elektrischen Geräts 1 zwischen den Gehäuseteilen 4 und 5 angebracht sind. Die Teile nach Figur 2 sind aufgrund ihrer identischen Funktion mit gleichen Bezugszeichen wie die Teile nach Figur 1 versehen.

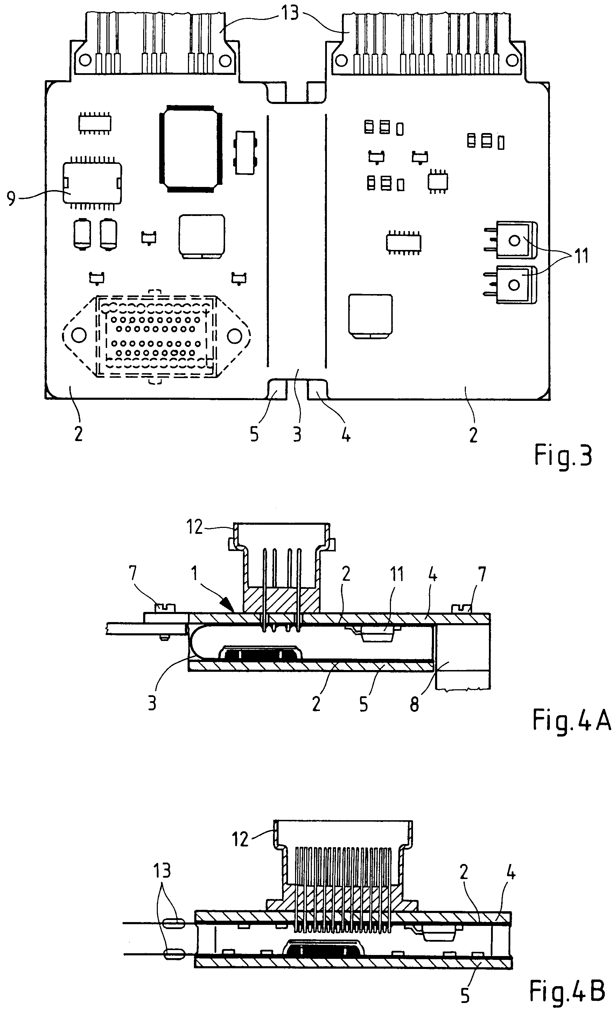

Figur 3 zeigt die Leiterplatte 2 in einem aufgeklappten Zustand, wie sie vor dem Zusammenbau zur Bestückung mit beispielsweise den Bauelementen 9 und 11 gehalten werden kann. Während der Bestückung können die Schaltungsebenen der Leiterplatte 2 bereits auf den Gehäuseteilen 4 und 5 gehalten werden und die elektrischen Bauelemente mittels eines Oberflächenbestückungsverfahrens (SMD) aufgebracht werden. Wenn Schaltungsteile, wie beispielsweise die Bauelemente 9 anhand der Figur 1, direkt am Gehäuseteil 5 gehalten sind, so werden diese in einem besonderen Arbeitsgang am Gehäuseteil 5 befestigt (z.B. durch Kleben). Die Kontakte dieser Bauelemente 9 ragen hierbei jedoch durch das Gehäuseteil 5 hindurch. Das gleiche gilt für den Steckerteil 12, der dann in einem späteren Arbeitsgang in gleicher Weise wie die zuvor beschriebenen Bauelemente 9 mit der Leiterplatte 2 beispielsweise durch Wellenlöten verbunden wird. Es ist hierbei auch möglich die beiden Schaltungsebenen der Leiterplatte 2 im flexiblen Bereich 3 aufzutrennen und getrennt zu bestücken. Das Zusammenfügen erfolgt dann vor dem endgültigen Zusammenbau des elektrischen Geräts 1 beispielsweise durch Stempellöten. Die beiden Gehäuseteile 4 und 5 dienen sodann als Teil einer Werkzeugform für den Umhüllungs- und Ausfüllungsprozeß mit der aushärtenden Schaumstoffmasse 6. Dabei wird das elektrische Gerät 1 in seiner Kontur definiert, abgedichtet und die Schaltungsebenen der Leiterplatte 2 ohne zusätzliche Hilfsmittel (Schrauben, Rahmen oder dgl.) bezüglich ihrer Lage fixiert.

Im oberen Bereich der Leiterplatte 2 sind gemäß Figur 3 noch weitere flexible Leiterbahnen 13 angebracht, die eine Herausführung von Steckverbindern aus dem elektrischen Gerät 1 ermöglichen. Hier sind die Leiterbahnen 13 durch Stempellöten mit der Leiterplatte 2 verbunden, denkbar ist jedoch auch eine vollständige Integration dieser Leiterbahnen 13 in eine flexible Leiterplatte 2.

Die Figuren 4A und 4B stellen jeweils einen Schnitt durch ein elektrisches Gerät 1 dar, bei dem eine Leiterplatte 2 nach Figur 3 im Gerät eingebracht ist. Der obere Schnitt nach Figur 4A ist mit der Darstellung nach Figur 2 vergleichbar; aus dem unteren Schnitt (Figur 4B) ist das Herausragen der flexiblen Leiterbahnen 13 erkennbar, mit denen eine direkte Ankopplung von zusätzlichen Bauelementen oder eine Steckverbindung mit weiteren elektrischen Geräten durchführbar ist.

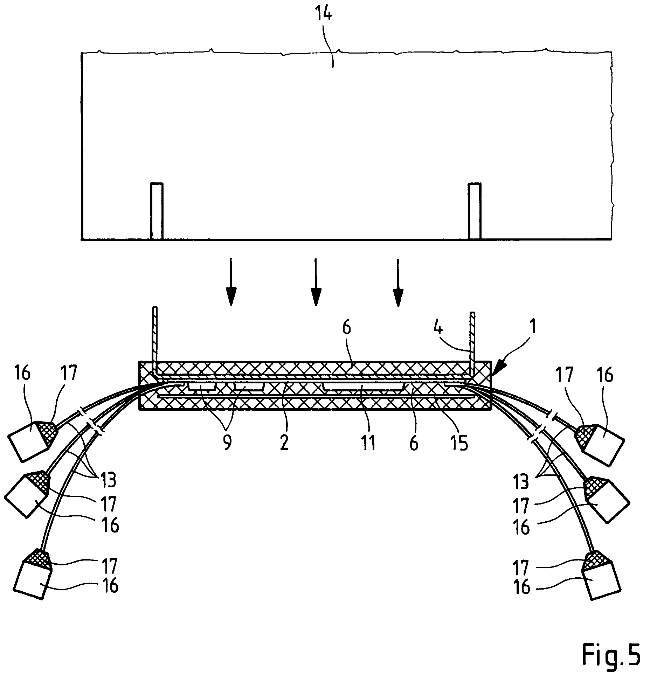

Ein drittes Ausführungsbeispiel für das erfindungsgemäße elektrische Gerät ist in der Figur 5 dargestellt. Hier ist das Gehäuseteil 4 zugleich als Kühlfläche aus der Schaumstoffmasse 6 herausgeführt. Die Bauelemente 9 und insbesondere das Leistungsbauelement 11, die auf der Leiterplatte 2 angeordnet sind, können so optimal gekühlt werden. Die Kühlwirkung wird noch verstärkt, wenn das gesamte elektrische Gerät 1 im Luftstrom eines Aggregats 14 untergbracht wird, wie um Beispiel im Luftstrom eines Luftfilters beim Verbrennungsmotor eines Kraftfahrzeugs.

Eine eventuell notwendige elektromagnetische Abschirmung ist hier auf einfache Weise dadurch erreicht, daß eine Aluminiumfolie 15 über die Bauelemente 9 und 11 gelegt ist, die mitsamt der Leiterplatte 2 und dem Gehäuseteil 4 von der aushärtenden, dichtenden Schaumstoffmasse 6 zusammengehalten werden.

An der Leiterplatte 2 sind hier noch eine Mehrzahl von flexiblen Leiterbahnen 13 vorhanden, die mit der Leiterplatte 2 beispielsweise über Lötkontakte und mechanisch mit dem elektrischen Gerät 1 über die umgebende Schaumstoffmasse verbunden sind. Am Ende dieser Leiterbahnen 13 sind Steckverbinder 16 vorhanden, die in befestigender und abdichtender Weise mit einem aushärtenden Schaumstoffmantel 17 umgeben sind.

## Patentansprüche

1. Elektrisches Gerät mit
- auf mindestens einer, teilweise aus flexiblem Material bestehenden, Leiterplatte (2) angeordneten elektrischen Bauelementen (9,11), mit
- flexiblen elektrischen Leiterbahnen (3;13), die mit der Leiterplatte (2) verbunden oder in diese integriert sind und mit
- mindestens einem festen Gehäuseteil (4,5) an dem die mindestens eine Leiterplatte (2) gehalten ist,
**dadurch gekennzeichnet, daß**
- die mindestens eine Leiterplatte (2) , die Gehäuseteile (4,5) und zumindest Teile der flexiblen Leiterbahnen (3;13) mit einer zunächst flüssigen, danach aushärtenden Schaumstoffmasse (6;17) derart umgeben sind, daß eine mechanisch haltbare Verbindung zwischen diesen Elementen hergestellt ist.

2. Elektrisches Gerät nach Anspruch 1
**dadurch gekennzeichnet, daß**
- eine Anzahl von flexiblen Leiterbahnen (13) aus dem elektrischen Gerät (1) herausgeführt sind, die mit, in eine Schaumstoffmasse (17) eingebetteten, Anschlußelementen (16) für jeweils unterschiedliche, an das elektrische Gerät (1) anzuschließende externe Bauteile versehen sind.

3. Elektrisches Gerät nach einem der Ansprüche 1 oder 2, **dadurch gekennzeichnet, daß**
- die Gehäuseteile (4,5) zwei ebene Platten sind, die auf ihren Innenseiten jeweils Schaltungsebenen der Leiterplatte (2) tragen, wobei die beiden Schaltungsebenen über eine der flexiblen Leiterbahnen (3) miteinander verbunden sind und daß
- die während der Montage gegeneinander beweglichen Gehäuseteile (4,5) durch die aushärtende Schaumstoffmasse (6) in einer parallelen Lage, mit innenliegender Leiterplatte (2), fixiert sind.

4. Elektrisches Gerät nach Anspruch 3,
**dadurch gekennzeichnet, daß**
- auch auf der Außenseite mindestens eines der Gehäuseteile (5) elektrische Bauelemente (9) angeordnet sind, deren Anschlüsse durch die Gehäuseteile (5) hindurchgeführt sind und die ebenfalls von der Schaumstoffmasse (6) umgeben sind.

5. Elektrisches Gerät nach einem der Ansprüche 1 bis 4,
**dadurch gekennzeichnet, daß**
- Teile der elektrischen Bauelemente (9) mit einer metallischen Abschirmung (10) umgeben sind.

6. Elektrisches Gerät nach Anspruch 5,
**dadurch gekennzeichnet, daß**
- die metallische Abschirmung aus einer in die Schaumstoffmasse eingelassenen Aluminiumfolie (15) besteht.

7. Elektrisches Gerät nach Anspruch 5,
**dadurch gekennzeichnet, daß**
- die metallische Abschirmung (10) aus einem auf das Gehäuseteile (5) heruntergeführten Blechteil besteht und nur auf der, der Leiterplatte (2) abgewandten Seite mit der Schaumstoffmasse (6) umgeben ist.

8. Elektrisches Gerät nach einem der Ansprüche 1 bis 7, **dadurch gekennzeichnet, daß**
- die Gehäuseteile (4,5) aus einem wärmeleitfähigem Metall sind.

9. Verfahren zur Herstellung eines elektrisches Gerät nach einem der Ansprüche 1 bis 8,
**dadurch gekennzeichnet, daß**
- in einem ersten Herstellungsschritt eine Bestückung der Leiterplatte (2) mit den elektrischen Bauelementen (9,11) vorgenommen wird,
- in einem Zweiten Herstellungsschritt die Leiterplatte (2) und die flexiblen Leiterbahnen (3;13) vorübergehend fixiert werden und daß
- in einem dritten Herstellungsschritt die Leiterplatte (2) und Leiterbahnen (3;13) mitsamt den Gehäuseteilen (4,5) in ihre Endlage gebracht und sodann mit der aushärtenden Schaumstoffmasse (6) umgeben werden.

10. Verfahren nach Anspruch 9,
**dadurch gekennzeichnet, daß**
- die Bestückung der Leiterplatte (2) zu einem Teil mit einem Oberflächenbestückungsverfahren (SMD) vorgenommen wird und daß
- das zum anderen Teil die elektrische Kontaktierung der Bauelemente (9,11) und der Steckverbinder (12) in einem Reflow-Lötverfahren vorgenommen wird.
